Europäisches Patentamt

European Patent Office

Office européen des brevets

(19)

(11) **EP 0 866 563 A2**

(12) **EUROPÄISCHE PATENTANMELDUNG**

(43) Veröffentlichungstag:
23.09.1998 Patentblatt 1998/39

(51) Int. Cl.⁶: **H03M 1/12**

(21) Anmeldenummer: 98200718.9

(22) Anmeldetag: 06.03.1998

(84) Benannte Vertragsstaaten:
**AT BE CH DE DK ES FI FR GB GR IE IT LI LU MC
NL PT SE**
Benannte Erstreckungsstaaten:
**AL LT LV MK RO SI**

(30) Priorität: **20.03.1997 DE 19711613**

(71) Anmelder:
• **Philips Patentverwaltung GmbH
22335 Hamburg (DE)**
Benannte Vertragsstaaten:
**DE**

• **Koninklijke Philips Electronics N.V.
5621 BA Eindhoven (NL)**
Benannte Vertragsstaaten:
**FR GB**

(72) Erfinder: **Volmari, Frank
Röntgenstrasse 24, 22335 Hamburg (DE)**

(74) Vertreter:
**von Laue, Hanns-Ulrich, Dipl.-Ing. et al
Philips Patentverwaltung GmbH,
Röntgenstrasse 24
22335 Hamburg (DE)**

(54) **Verfahren und Anordnung zur Analog-/Digital-Umsetzung eines Bildsignals**

(57) Für ein Verfahren zur Analog-/Digital-Umsetzung sowie eine Anordnung zur Umsetzung eines analogen Signals, insbesondere eines Bildsignals, in ein digitales Signal mittels wenigstens zweier Analog-/Digital-Umsetzer (1,2;11,12), welche mittels wenigstens zweier phasenverschobener Taktsignale getaktet werden und deren Ausgangssignale mittels eines Multiplexers (3;13) zu einem digitalen Signal zusammengefügt werden, ist zur individuellen Anpassung an die differierenden Eigenschaften der Analog-/Digital-Umsetzer (1,2;11,12) vorgesehen, daß jedem Analog-/Digital-Umsetzer (1,2;11,12) jeweils eine Anordnung zur automatischen Verstärkungsregelung (4;14,17;22,24) und eine Klemmstufe (6;16,19;23,25), die eine Klemmung des Bildsignals auf einen vorgegebenen Amplitudenwert vornimmt, vorgeschaltet sind, denen das analoge Signal zugeführt wird.

Fig.2

EP 0 866 563 A2

**Beschreibung**

Die Erfindung betrifft ein Verfahren sowie eine Anordnung zur Analog-/Digital-Umsetzung eines analogen Signals, insbesondere eines Bildsignals, in ein digitales Signal mittels wenigstens zweier Analog-/Digital-Umsetzer, welche phasenverschoben getaktet werden und deren Ausgangssignale zu einem digitalen Signal zusammengefügt werden.

Aus der DE-OS 35 43 744 ist ein derartiges Verfahren bekannt, bei dem ein analoges Signal mehreren parallel angeordneten Analog-/Digital-Umsetzern zugeführt wird. Die Ausgangssignale der Analog-/Digital-Umsetzer werden zeitlich verschachtelt zusammengefügt und stehen als Ausgangssignal zur Verfügung. Dieses Ausgangssignal kann eine Taktfrequenz haben, die n mal so hoch ist wie die Abtasttacktfrequenz der einzelnen Analog-/Digital-Umsetzer, wenn n Analog-/Digital-Umsetzer vorgesehen sind.

Der Hauptnachteil dieses Verfahrens besteht darin, daß in der Praxis Analog-/Digital-Umsetzer und analoge Vorfilter verschiedene Kennlinien und verschiedene Empfindlichkeiten aufweisen. Damit entsteht in dem Ausgangssignal, in dem zeitlich verschachtelt die Ausgangssignale der Analog-/Digital-Umsetzer enthalten sind, eine Ungenauigkeit, die zeitlich schwankt. So kann beispielsweise selbst bei konstantem Eingangssignal das Ausgangssignal zeitlich schwankende Werte aufweisen. Darüber hinaus können quasi abhängig davon, zu welchem Zeitpunkt das Eingangssignal abgetastet wird, und damit also mittels welches der Analog-/Digital-Umsetzer das Signal abgetastet wird, differierende Ausgangssignale erscheinen. Bei diesem Verfahren ändern sich somit abhängig davon, welcher Analog-/Digital-Umsetzer gerade das Eingangssignal abtastet, die Empfindlichkeit und/oder Kennlinie der Schaltung und damit die Werte des digitalen Ausgangssignals. Dies ist unerwünscht.

Es ist Aufgabe der Erfindung, ein Verfahren sowie eine Anordnung anzugeben, bei denen diese Probleme nicht auftreten.

Diese Aufgabe ist erfindungsgemäß fuhr ein Verfahren dadurch gelöst, daß das analoge Signal vor der Analog-/Digital-Umsetzung getrennt für die den Analog-/Digital-Umsetzern zugeführten Signale einer automatischen Verstärkungsregelung und einer Klemmung auf einen vorgegebenen Amplitudenwert unterzogen wird.

Das analoge Signal wird jedem der Analog-/Digital-Umsetzer zugeführt. Zuvor wird jedoch jedes der Signale, die den Analog-/Digital-Umsetzern zugeführt werden, getrennt einer automatischen Verstärkungsregelung und einer Klemmung auf einen vorgegebenen Amlitudenwert unterzogen. Damit kann individuell für jeden Analog-/Digital-Umsetzer eine Anpassung von dessen Eingangssignal an die Empfindlichkeit und die Kennlinie des Analog-/Digital-Umsetzers und des Vorfilters vorgenommen werden. Dies bedeutet, daß die Analog-/Digital-Umsetzer ausgangsseitig digitale Signale liefern, die mit gleicher Kennlinie und gleicher Empfindlichkeit aus dem eingangsseitigen analogen Signal erzeugt wurden. Damit ergibt sich in dem Gesamt-Ausgangssignal des Verfahrens ein digitales Signal, das zu jedem Zeitpunkt mit gleicher Empfindlichkeit und gleicher Kennlinie aus dem analogen Eingangssignal erzeugt wurde. Es ergeben sich somit keine zeitlichen Schwankungen dieses Ausgangssignals mehr.

Gemäß einer Ausgestaltung der Erfindung ist für das Verfahren vorgesehen, daß getrennt für die den Analog-/Digital-Umsetzern zugeführten Signale eine Anti-Aliasing-Filterung vorgenommen wird. Vorteilhafterweise kann eine derartige Anti-Aliasing-Filterung vorgenommen werden, welche diejenigen Frequenzen unterdrückt, die gemäß des Abtasttheorems in Abhängigkeit der Abtastfrequenz der Analog-/Digital-Umsetzer durch diese ohnehin nicht mehr umgesetzt werden können und daher ausschließlich zu Störungen in dem Ausgangssignal führen.

Gemäß einer weiteren Ausgestaltung des erfindungsgemäßen Verfahrens ist vorgesehen, daß die automatische Verstärkungsregelung und/oder Klemmung in Abhängigkeit des digitalen Signals vorgenommen werden.

Der Ausgleich der unterschiedlichen Empfindlichkeiten und/oder Kennlinien der Analog-/Digital-Umsetzer kann einerseits fest eingestellt werden. Gemäß dieser vorteilhaften Ausgestaltung besteht jedoch auch die Möglichkeit, die automatische Verstärkungsregelung und die Klemmung in Abhängigkeit des digitalen Signals vorzunehmen, so daß nicht nur eine individuelle Anpassung der Verstärkungsregelung und der Klemmung in Abhängigkeit der Empfindlichkeit und der Kennlinien der Analog-/Digital-Umsetzer vorgenommen werden kann, sondern auch eine zeitliche Anpassung dieser Parameter, beispielsweise um Temperaturdrifts der Analog-/Digital-Umsetzer ebenfalls auszugleichen.

Gemäß einer weiteren Ausgestaltung des erfindungsgemäßen Verfahrens ist vorgesehen, daß für die Taktfrequenz $f_{sample}$ der den Analog-/Digital-Umsetzern zugeführten Taktsignale, die Taktfrequenz $f_{clock}$ des digitalen Signals und die Zahl m der Analog-/Digital-Umsetzer gilt

$$m = \frac{f_{clock}}{f_{sample}} .$$

Dies bedeutet, daß bei einer Zahl von m der Analog-/Digital-Umsetzer das digitale Ausgangssignal eine Taktfrequenz aufweist, die m mal so hoch ist wie die Taktfrequenz der Analog-/Digital-Umsetzer. Damit kann ein digitales Signal erzeugt werden, welches mit einer m-mal höheren Taktfrequenz vorliegt, als dies mit einem einzelnen Analog-/Digital-Umsetzer möglich wäre.

Die oben genannte Aufgabe ist für eine Anordnung zur Analog-/Digital-Umsetzung eines analogen Signals, insbesondere eines Bildsignals, in ein digitales Signal mittels wenigstens zweier Analog-/Digital-Umsetzer, welche mittels wenigstens zweier phasenverschobener Taktsignale getaktet werden und deren Ausgangssignale mittels eines Multiplexers zu einem digitalen Bildsignal zusammengefügt werden, dadurch gelöst, daß jedem Analog-/Digital-Umsetzer jeweils eine Anordnung zur automatischen Verstärkungsregelung und eine Klemmstufe, die eine Klemmung des Bildsignals auf einen vorgegebenen Amplitudenwert vornimmt, vorgeschaltet sind, denen das analoge Signal zugeführt wird.

Das analoge Signal wird zunächst Anordnungen zur automatischen Verstärkungsregelung und Klemmstufen zugeführt. Je Analog-/Digital-Umsetzer ist jeweils individuell eine derartige Anordnung zur automatischen Verstärkungsregelung sowie eine Klemmstufe vorgesehen. Damit können die den Analog-/Digital-Umsetzern zugeführten Signale individuell bezüglich Empfindlichkeit und Kennlinie an die Eigenschaften der Analog-/Digital-Umsetzer und analogem Vorfilter angepaßt werden. Damit werden deren unterschiedliche Empfindlichkeiten bzw. Kennlinien korrigiert, so daß das Ausgangssignal jeweils mit gleicher Empfindlichkeit und Kennlinie aus dem analogen Eingangssignal erzeugt wird, unabhängig davon, von welchem der Analog-/Digital-Umsetzer es abgetastet wurde.

Für eine Ausgestaltung der erfindungsgemäßen Anordnung ist vorgesehen, daß dem Multiplexer eine Steuerungsschaltung nachgeschaltet ist, welche in Abhängigkeit der Amplitudenwerte des digitalen Signals die Anordnungen zur automatischen Verstärkungsregelung und/oder die Klemmstufen steuert.

Die Ausgangssignal der verschiedenen Analog-/Digital-Umsetzer werden mittels des Multiplexers zu dem Ausgangssignal der Anordnung zusammengefügt. In diesem Ausgangssignal der Anordnung liegen die Ausgangssignale der Analog-/Digital-Umsetzer in zeitlich aufeinanderfolgenden Zeitfenstern vor. Damit ist bekannt, in welchem Zeitfenster das Ausgangssignal welches Analog-/Digital-Umsetzers auftritt. Dieses Ausgangssignal wird mittels der Steuerungsschaltung analysiert und es werden in Abhängigkeit der Amplitudenwerte des digitalen Signals die den jeweiligen Analog-/Digital-Umsetzern zugeordneten Anordnungen zur automatischen Verstärkungsregelung und/oder Klemmstufen so gesteuert, daß das digitale Signal mit gewünschter Empfindlichkeit und/oder Kennlinie vorliegt. Damit werden nicht nur die individuell unterschiedlichen Eigenschaften der Analog-/Digital-Umsetzer ausgeglichen, sondern es findet zusätzlich eine zeitliche Anpassung statt, die beispielsweise ggf. auftretende Temperaturdrifts der Analog-/Digital-Umsetzer ausgleichen kann.

Nachfolgend wird anhand der Zeichnung eine erfindungsgemäße Anordnung erläutert, welche gemäß des erfindungsgemäßen Verfahren arbeitet. Es zeigen:

Fig. 1 eine Anordnung mit zwei Analog-/Digital-Umsetzern, denen jeweils getrennte Anordnungen zur automatischen Verstärkungsregelung, zur Klemmung und zur Anti-Aliasing-Filterung vorgeschaltet sind, und

Fig. 2 eine Anordnung gemäß Fig. 1, bei der zusätzlich eine individuelle Regelung der Anordnungen zur automatischen Verstärkungsregelung und der Klemmstufen in Abhängigkeit des digitalen Signals vorgenommen wird.

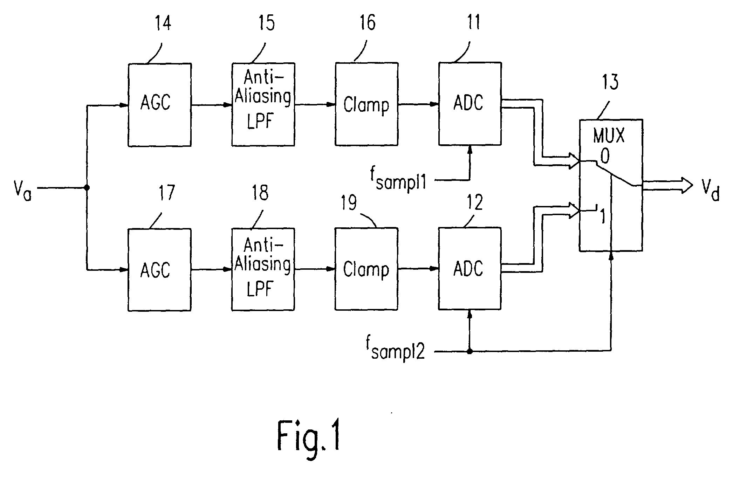

Eine in Fig. 1 in Form eines Blockschaltbildes dargestellte erfindungsgemäße Anordnung zur Analog-/Digital-Umsetzung eines analogen Signals $V_a$ in ein digitales Signal $V_d$, bei dem es sich insbesondere um ein Bildsignal handeln kam, weist einen ersten Analog-/Digital-Umsetzer 11 sowie einen zweiten Analog-/Digital-Umsetzer 12 auf.

Der erste Analog-/Digital-Umsetzer 11 wird mittels eines Taktsignals $f_{sampl1}$ und der zweite Analog-/Digital-Umsetzer 12 mittels eines Taktsignals $f_{sampl2}$ getaktet. Beide Taktsignale weisen die gleiche Frequenz auf, sind jedoch zueinander phasenverschoben.

Die Ausgangssignale der Analog-/Digital-Umsetzer 11 und 12 werden mittels eines Multiplexers 13 zu einem gemeinsamen Digitalsignal, dem Ausgangssignal $V_d$ der Anordnung, zusammengefügt. Der Multiplexer 13 wird mittels des zweiten Taktsignals $f_{sampl2}$ getaktet, wobei er jeweils bei einer positiven und bei einer negativen Flanke zwischen den Ausgangssignalen der beiden Analog-/Digital-Umsetzer 11 und 12 umschaltet.

Durch die vorgesehene Phasenverschiebung zwischen den beiden Taktsignalen $f_{sampl1}$ und $f_{sampl2}$ wird erreicht, daß die analogen Eingangssignale der Analog-/Digital-Umsetzer 11 und 12 zu verschiedenen Zeitpunkten abgetastet werden. Diese Abtastwerte werden mittels des Multiplexers zeitlich ineinander verschachtelt zusammengefügt.

Wie oben erläutert, dient die Anordnung dazu, daß ihr eingangsseitig zugeführte digitale Bildsignal $V_a$ in das digitale Signal $V_d$ umzusetzen. Da jedoch die beiden Analog-/Digital-Umsetzer 11 und 12 jeweils verschiedene Empfindlichkeiten und/oder Kennlinien aufweisen können, wird das analoge Signal $V_a$ individuell aufbereitet. Dies bedeutet, daß das Signal individuell für die beiden Analog-/Digital-Umsetzer 11 bzw. 12 an deren ggf. differierende Eigenschaften angepaßt wird.

So wird das analoge Signal $V_a$ einer Anordnung zur automatischen Verstärkungsregelung 14 zugeführt, der ein Anti-Aliasing-Filter 15 nachgeschaltet ist, dessen Ausgangssignal auf eine Klemmstufe 16 gelangt, die dem ersten Analog-/Digital-Umsetzer 11 vorgeschaltet ist.

Mittels der Anordnung der automatischen Verstärkungsregelung wird die Verstärkung des analogen Signals eingestellt. Mittels der Klemmstufe 16 kann die Offseteinstellung des Signals vorgenommen werden. Damit wird das dem Analog-/Digital-Umsetzer 11 zugeführte Signal bezuglich dieser Eigenschaften an die Eigenschaften des Analog-/Digital-Umsetzers 11 angepaßt. Diese Anpassung erfolgt individuell für diesen Umsetzer 11.

In entsprechender Weise sind dem zweiten Analog-/Digital-Umsetzer 12 eine Anordnung zur automatischen Verstärkungsregelung 17, ein Anti-Aliasing-Filter 18 und eine Klemmstufe 19 vorgeschaltet, die in entsprechender Weise eine Anpassung des analogen Signals an die Eigenschaften des Analog-/Digital-Umsetzers 12 vornehmen.

Damit wird im Ergebnis erreicht, daß das analoge Eingangssignal $V_a$ individuell für jeden der Analog-/Digital-Umsetzer 11 oder 12 (oder für weitere eventuell vorgesehene Analog-/Digital-Umsetzer) individuell an deren Eigenschaften und die der Anti-Aliasing-Filter angepaßt werden kann, sodaß das Ausgangssignal der Anordnung $V_b$ zu jedem Zeitpunkt mit gleichen Parametern durch Abtastung aus dem analogen Signal $V_a$ hervorgeht. Es ergeben sich somit keine zeitlichen Schwankungen dieser Parameter in dem Ausgangssignal $V_d$ mehr.

Die Anti-Aliasing-Filter 15 und 18 sind zusätzlich dazu vorgesehen, diejenigen Frequenzanteile in dem analogen Signal zu unterdrücken, die in Abhängigkeit der Abtastfrequenzen $f_{sampl1}$ bzw. $f_{sampl2}$ ohnehin nicht von den Analog-/Digital-Umsetzern 11 bzw. 12 umgesetzt werden könnten und die nur Störungen verursachen würden.

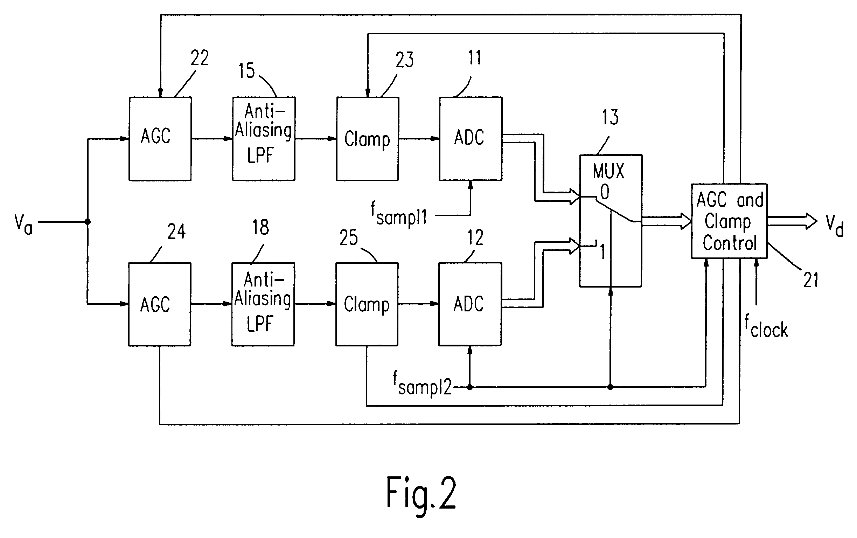

In Fig. 2 ist ein Blockschaltbild einer erfindungsgemäßen Anordnung entsprechend derjenigen gemäß Fig. 1 dargestellt, bei der zusätzlich eine Steuerung der Anordnungen zur Verstärkungsregelung 22 und 24 und der Klemmstufen 23 und 25 in Abhängigkeit des digitalen Signals $V_d$ vorgenommen wird.

Hierzu ist dem Multiplexer 13 eine Steuerung 21 nachgeschaltet, welche dem digitalen Signal $V_d$ Abtastwerte entnimmt. Da in dem digitalen Signal $V_d$ die Ausgangssignale der Analog-/Digital-Umsetzer 11 bzw. 12 zu vorgegebenen, zeitlich ineinander verschachtelten Zeitschlitzen vorliegen, kann das Ausgangssignal bzw. dessen Werte den jeweiligen Analog-/Digital-Umsetzern 11 und 12 zugeordnet werden.

In Abhängigkeit dieser den Analog-/Digital-Umsetzern 11 bzw. 12 individuell zugeordneten Werte können die Anordnungen 22 bzw. 24 zur automatischen Verstärkungsregelung und die Klemmstufen 23 und 25 in Abhängigkeit des digitalen Ausgangssignals $V_d$ geregelt werden.

Durch die Steuerung 21 kann somit jederzeit ein Vergleich der analogen Signale, wie sie Anordnungen 22 bzw. 24 und 23 bzw. 25 durchlaufen, mit den in dem digitalen Bereich umgesetzten Werten vorgenommen werden. Somit ist eine Anpassung der Verstärkung und des Offsets dieser Werte möglich, indem die automatische Verstärkungsregelung bzw. die Klemmstufen entsprechend gesteuert werden.

Es kann somit nicht nur eine feste Voreinstellung der Anordnungen 22 bzw. 24 zur automatischen Verstärkungsregelung und der Klemmstufen 23 und 25 vorgenommen werden, sondern diese können vielmehr zeitlich an sich ggf. ändernde Werte der Empfindlichkeit oder der Kennlinie der Analog-/Digital-Umsetzer 11 bzw. 12 und der Anti-Aliasing-Filter 15 bzw. 18 angepaßt werden. Derartige zeitliche Änderungen dieser Parameter können beispielsweise durch Temperaturdrifts entstehen.

## Patentansprüche

1. Verfahren zur Analog-/Digital-Umsetzung eines analogen Signals, insbesondere eines Bildsignals, in ein digitales Signal mittels wenigstens zweier Analog-/Digital-Umsetzer (1,2;11,12), welche phasenverschoben getaktet werden und deren Ausgangssignale zu einem digitalen Signal zusammengefügt werden,
   dadurch gekennzeichnet, daß das analoge Signal vor der Analog-/Digital-Umsetzung getrennt für die den Analog-/Digital-Umsetzern (1,2;11,12) zugeführten Signale einer automatischen Verstärkungsregelung und einer Klemmung auf einen vorgegebenen Amplitudenwert unterzogen wird.

2. Verfahren nach Anspruch 1,
   dadurch gekennzeichnet, daß getrennt fuhr die den Analog-/Digital-Umsetzern (1,2;11,12) zugeführten Signale eine Anti-Aliasing-Filterung vorgenommen wird.

3. Verfahren nach Anspruch 1 oder 2,
   dadurch gekennzeichnet, daß die automatische Verstärkungsregelung und/oder Klemmung in Abhängigkeit des digitalen Signals vorgenommen werden.

4. Verfahren nach einem der Ansprüche 1 bis 3,
   dadurch gekennzeichnet, daß für die Taktfrequenz $f_{sample}$ der den Analog-/Digital-Umsetzern (1,2;11,12) zugeführten Taktsignale, die Taktfrequenz $f_{clock}$ des digitalen Signals und die Zahl m der Analog-/Digital-Umsetzer (1,2;11,12) gilt

$$m = \frac{f_{clock}}{f_{sample}} \ .$$

5. Anordnung zur Analog-/Digital-Umsetzung eines analogen Signals, insbesondere eines Bildsignals, in ein digitales Signal mittels wenigstens zweier Analog-/Digital-Umsetzer (1,2;11,12), welche mittels wenigstens zweier phasenverschobener Taktsignale getaktet werden und deren Ausgangssignale mittels eines Multiplexers (3;13) zu einem digitalen Bildsignal zusammengefügt werden, dadurch gekennzeichnet, daß jedem Analog-/Digital-Umsetzer (1,2;11,12) jeweils eine Anordnung zur automatischen Verstärkungsregelung (4;14,17;22,24) und eine Klemmstufe (6;16,19;23,25), die eine Klemmung des Bildsignals auf einen vorgegebenen Amplitudenwert vornimmt, vorgeschaltet sind, denen das analoge Signal zugeführt wird.

6. Anordnung nach Anspruch 5, dadurch gekennzeichnet, daß jedem Analog-/Digital-Umsetzer (1,2;11,12) jeweils ein Anti-Aliasing-Filter (5;15,18) vorgeschaltet ist.

7. Anordnung nach Anspruch 5 oder 6, dadurch gekennzeichnet, daß dem Multiplexer (3;13) eine Steuerungsschaltung (21) nachgeschaltet ist, welche in Abhängigkeit der Amplitudenwerte des digitalen Signals die Anordnungen zur automatischen Verstärkungsregelung (22,24) und/oder die Klemmstufen (23,25) steuert.

8. Anordnung nach einem der Ansprüche 5 bis 7, dadurch gekennzeichnet, daß für die Taktfrequenz $f_{sample}$ der den Analog-/Digital-Umsetzern (1,2;11,12) zugeführten Taktsignale, die Taktfrequenz $f_{clock}$ des digitalen Signals und die Zahl m der Analog-/Digital-Umsetzer (1,2;11,12) gilt

$$m = \frac{f_{clock}}{f_{sample}} \; .$$

9. Digitales Bildsignal, dadurch gekennzeichnet, daß das Bildsignal mittels einer Anordnung nach einem der Ansprüche 5 bis 8 erzeugt ist.

10. Digitaler Video-Enkoder mit einer Anordnung nach einem der Ansprüche 5 bis 8.

11. Digitaler Video-Dekoder mit einer Anordnung nach einem der Ansprüche 5 bis 8.

Fig.1

Fig.2

EP 0 866 563 A2